Europäisches Patentamt

European Patent Office

Office européen des brevets

(11) Veröffentlichungsnummer: **0 216 945**
**B1**

(12) # EUROPÄISCHE PATENTSCHRIFT

(45) Veröffentlichungstag der Patentschrift:
05.07.89

(51) Int. Cl.⁴: **H01L 21/285, H01L 21/60**

(21) Anmeldenummer: **85111972.7**

(22) Anmeldetag: **21.09.85**

(54) Verfahren zum Anbringen eines Kontaktes an einem Kontaktbereich eines Substrats aus Halbleitermaterial.

(43) Veröffentlichungstag der Anmeldung:
**08.04.87 Patentblatt 87/15**

(45) Bekanntmachung des Hinweises auf die Patenterteilung:
**05.07.89 Patentblatt 89/27**

(84) Benannte Vertragsstaaten:
**DE FR GB IT NL**

(56) Entgegenhaltungen:
EP-A- 0 142 632
US-A- 4 381 953

IBM TECHNICAL DISCLOSURE BULLETIN, Band 24,
Nr. 7A, Dezember 1981, Seiten 3424-3426, New York, US;
F. BARSON et al.: "Polycide bipolar transistor process"
IBM TECHNICAL DISCLOSURE BULLETIN, Band 23,
Nr. 12, Mai 1981, Seiten 5384-5387, New York, US; C.G.
JAMBOTKAR: "Compact NPN transistor"

(73) Patentinhaber: **Deutsche ITT Industries GmbH,
Hans-Bunte-Strasse 19 Postfach 840,
D-7800 Freiburg(DE)**
(84) Benannte Vertragsstaaten: **DE**

(73) Patentinhaber: **ITT INDUSTRIES INC., 320 Park Avenue,
New York, NY 10022(US)**
(84) Benannte Vertragsstaaten: **FR GB IT NL**

(72) Erfinder: **Blossfeld, Lothar, Dipl.-Phys., Waldstrasse 23,
D-7801 Freiburg-Hochdorf(DE)**

(74) Vertreter: **Klunker . Schmitt-Nilson . Hirsch,
Winzererstrasse 106, D-8000 München 40(DE)**

**Beschreibung**

Die Erfindung beschäftigt sich mit einem Verfahren zum Anbringen eines selbstjustierten Kontaktes in unmittelbarer Nähe einer Elektrodenschicht aus polykristallinem Silizium. Ein derartiges Verfahren ist aus der DE-A1-32 43 059 bekannt und hat insbesondere Bedeutung bei integrierten Bipolartransistoren für Höchstfrequenzschaltungen.

Bei dem Verfahren der vorstehend genannten Offenlegungsschrift werden sowohl für die Elektrodenschicht als auch für den Kontakt entsprechend dem Grundgedanken der Offenlegungsschrift sowohl für die Emitterelektrodenschicht als auch für den Basiskontakt polykristallines Silizium verwendet, das entsprechend dem Leitungstyp der zu kontaktierenden Zonen dotiert ist und sowohl als Diffusionsquelle als auch als Kontaktierungsmaterial verwendet wird. In diesem Falle sind naturgemäß die Emitter-Elektrodenschicht auf die Emitterzone und der Basiskontakt auf die äußere inaktive Basiszone ausgerichtet. Die gegenseitige Ausrichtung der einzelnen Kontakte auf die jeweils zu kontaktierende Zone ist somit nicht den Ausrichttoleranzen eines photolithiographischen Prozesses unterworfen. Bei diesem bekannten Verfahren wird eine gleichmäßige Flankenisolation des Basiskontaktes gegen die Emitterelektrode durch ein besonderes Trockenätzverfahren erreicht, so daß auch die Kontakte mit ihren Zonen zueinander selbstjustiert sind.

Eine solche Selbstjustierung ist auch bei den sogenannten "SST"-Strukturen gegeben, wie sie aus "Japanese Journal of Applied Physics" Bd. 20 (1981) Suppl. 20-1, Seiten 155 bis 159, bekannt sind, und beruht auf der Herstellung der Flankenisolation unter Anwendung einer thermischen Oxidation des polykristallinen Siliziums.

Die oben erwähnten Verfahren haben den Nachteil einer Beschränkung des Materials von Elektrodenschicht und Kontakt auf polykristallines Silizium. Ein weiterer wesentlicher Nachteil ist darin zu sehen, daß eine Überlappung von Elektrodenschicht und Kontakt nicht vermeidbar ist. Diese Überlappung ist aber Ursache einer erhöhten Emitter-Basis-Kapazität bei integrierten Höchstfrequenzschaltungen, welche solche Bipolartransistoren enthalten, wie sie in den vorstehend genannten Literaturstellen beschrieben sind.

Aufgabe der Erfindung ist daher die Angabe eines Verfahrens, welches bei integrierten Schaltungen die selbstjustierende Herstellung eines Kontaktes in unmittelbarer Nähe einer Elektrodenschicht ohne Überlappung erlaubt.

Die Erfindung betrifft somit ein Verfahren zur Anbringung eines Kontaktes an einem Kontaktbereich eines Substrats aus Halbleitermaterial in unmittelbarer Nähe einer Elektrodenschicht aus polykristallinem Silizium, das mit dem Substrat an der Kontaktfläche der Elektrodenschicht verbunden ist, gemäß dem Oberbegriff des Anspruchs 1. Es wird dabei also vorausgesetzt, daß der Rand der Elektrodenschicht zumindest teilweise über einen rahmenförmigen Schichtteil aus einem Isoliermaterial mit dem Substrat verbunden ist. Bei den bekannten Bipolartransistoren der vorstehend genannten Literaturstellen ist dies aufgrund der erwähnten Überlappung über den gesamten Rand der Elektrodenschicht der Fall.

Die oben genannte Aufgabe wird erfindungsgemäß durch die im kennzeichnenden Teil des Anspruchs 1 angegebenen Verfahrensmaßnahmen gelöst.

Die wesentlichen Merkmale des Verfahrens nach der Erfindung sind also die Verwendung der Elektrodenschicht als Ätzmaske, um zumindest über einen Teil des Randes der Elektrodenschicht die Halbleiteroberfläche freizulegen, und die Verwendung eines ein Silizid bildenden Metalls, welches sowohl mit der Elektrodenschicht als auch mit dem Substrat oberflächlich eine Silizidschicht bildet. Beispiele solcher Metalle sind Wolfram oder Platin, vgl. "IEEE Electron Device Letters ", Bd. EDL-6, Nr. 7, (Juli 1985), Seiten 372 bis 374. Weitere Beispiele sind Molybdän, Tantal oder Titan, wie sie aus der DE-A1-33 15 719 bekannt sind.

Die Erfindung wird im folgenden anhand der Zeichnungen erläutert,

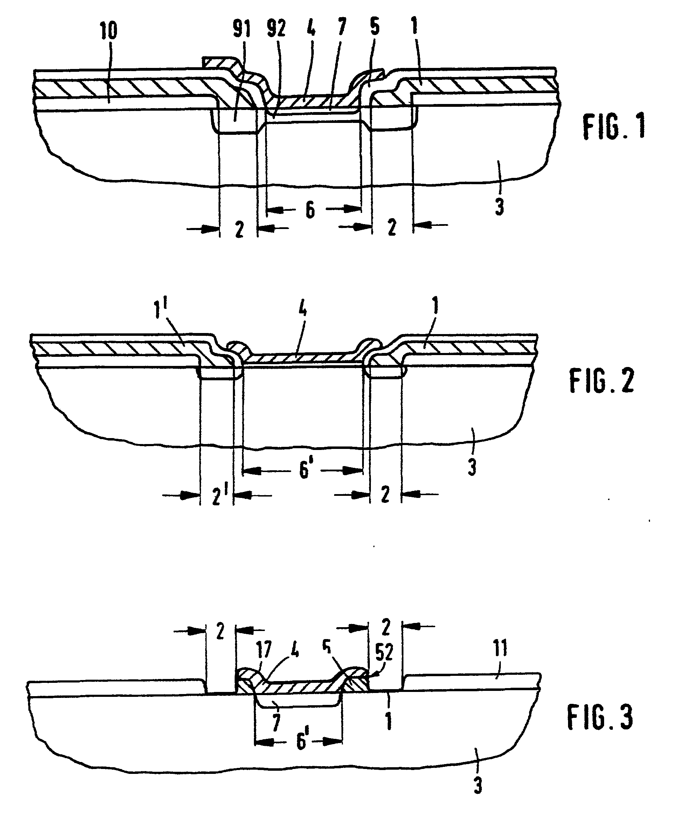

deren Fig. 1 zur Erläuterung der eingangs erwähnten bekannten Verfahren dient,

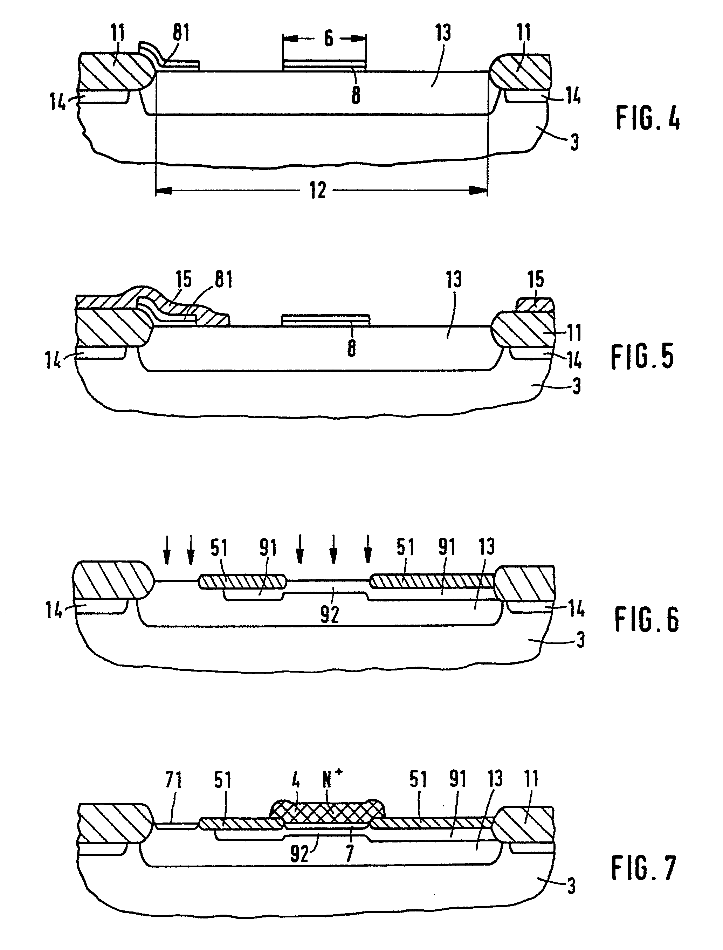

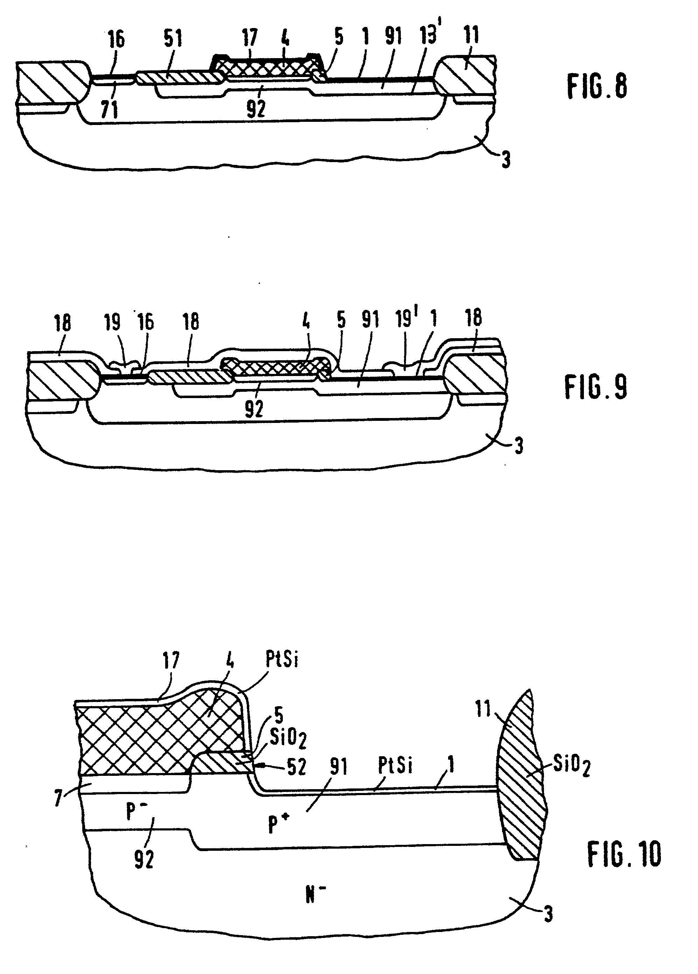

deren Fig. 2 eine Anwendungsmöglichkeit des Verfahrens nach der Erfindung betrifft,

deren Fig. 3 zur Erläuterung der für das Verfahren der Erfindung wesentliche Prozeßschritte dient,

deren Fig. 4 bis 9 aufeinanderfolgende Arbeitsstadien der bevorzugten Anwendung dus Verfahrens nach der Erfindung bei der Herstellung eines Bipolartransistors einer monolithisch integrierten Höchstfrequenzschaltung veranschaulichen und

deren Fig. 10 einen Ausschnitt eines nach den Verfahren der Erfindung hergestellten integrierten Bipolartransistors in einem Stadium zeigt, in welchem die wesentlichen Vorteile des Verfahrens nach der Erfindung besonders deutlich werden.

Das Verfahren der Erfindung ist mit größtem Vorteil bei der Herstellung von monolithisch integrierten Höchstfrequenzschaltungen mit integrierten Bipolartransistoren anwendbar, die aus der EP-A1-71 665 bekannt ist. Bei diesem Verfahren werden im wesentlichen unter Verwendung einer den Emitterbereich eines integrierten Bipolartransistors abdeckenden Oxidationsmaskierungsschicht in bestimmter Dicke zwei aufeinanderfolgende Implantationsprozesse unterschiedlicher Beschleunigungsenergie durchgeführt, wobei einmal die Dotierungen der inaktiven Basiszone und das andere Mal die Dotierungen der aktiven Basiszone implantiert werden. Die Oxidationsmaskierungsschicht ermöglicht ferner die Herstellung der Implantationsmaske für die Dotierungen der Emitterzone in selbstjustierender Weise zur Basiszone. Bei diesem bekannten Verfahren ist jedoch die Herstellung von zueinander und zu den Zonen selbstjustierenden Kontakten bzw. Elektroden nicht vorgesehen. Dazu liefert das Verfahren nach der Erfindung eine äußerst vorteilhafte Lösung.

Fig. 1 veranschaulicht im Querschnitt einen integrierten Bipolartransistor, wie er nach den Verfahren der eingangs genannten Literaturstellen in dem Substrat 3 herstellbar ist. Zu diesem Zweck wird das Substrat 3 thermisch oxidiert und nach Abgrenzung einer Feldoxidschicht 10 ein Bereich der Substratoberfläche freigelegt, der den Kontaktbereich 2 der inaktiven äußern Basiszone 91 und den Emitterbereich 6 der Emitterzone 7 einschließt. Beispielsweise durch Aufdampfen von Silizium, welches Dotierungen vom Leitungstyp der Basiszone enthält, wird unter Anwendung eines photolithographischen Ätzprozesses der Kontakt der inaktiven Basiszone 91 aufgebracht, der den Emitterbereich 6 umgibt. Zur Flankenisolation des Basis-Kontakes 1 gegen die noch herzustellende Emitter-Eletrodenschicht 4 wird bei dem Verfahren der genannten DE-A1-32 43 059 eine SiO$_2$-Schicht aufgebracht und die Anordnung einem besonderen Ätzverfahren unterworfen, so daß der rahmenförmige Schichtteil 5 entsteht. Alternativ kann zu diesem Zweck gemäß der eingangs genannten Literaturstelle aus "Japanese Journal of Applied Physics" ein thermischer Oxidationsprozeß des Basis-Kontaktes 1 erfolgen. Nach Herstellung der Emitter- Elektrodenschicht 4 aus polykristallinem Material, welches Dotierungen des Leitfähigkeitstyp der Emitterzone 7 enthält, durch Anwendung eines Aufdampfprozesses und eines photolithographischen Ätzprozesses wird die Anordnung auf eine zur Diffusion der Dotierungen aus den polykristallinen Siliziumschichten ausreichende Temperatur erhitzt. Auf diese Weise wird ein integrierter Bipolartransistor gemäß der Fig. 1 erhalten, dessen Basis-Kontakt 1 zur inaktiven Basiszone 91, dessen Emitter-Elektrodenschicht 4 zur Emitterzone 7 und dessen Zonenteile untereinander in selbstjustierender Weise ausgebildet wurden. Die Dotierungen der aktiven Basiszone 92 werden vor dem Aufbringen der Emitter-Elektrodenschicht 4 unter Anwendung eines Ionenimplantationsprozesses in die freiliegende Oberfläche des Substrats 3 eingebracht.

In gleicher Weise, wie anhand der Fig. 1 beschrieben, kann natürlich auch eine Halbleiteranordnung hergestellt werden, wie die Fig. 2 im Querschnitt zeigt, nämlich eine MOS-Kapazitätsdiode, deren Kontakt 1 in unmittelbarer Nähe der MOS-Elektrodenschicht an der Oberfläche des Substrats 3 angebracht ist, um einen möglichst geringen Bahnwiderstand zum Bereich unterhalb der Kontaktfläche 6' der Elektrodenschicht 4 zu erzielen.

Die Fig. 3 veranschaulicht eine der einfachsten Anwendungen des Verfahrens nach der Erfindung zum Herstellen einer integrierten PN-Planardiode mit der einen PN-Übergang im Substrat 3 bildenden Zone 7, welche mit der Elektrodenschicht 4 kontaktiert ist. Zu der Herstellung der PN-Planardiode können beispielsweise die Oberfläche des Substrats 3 thermisch oxidiert und durch Anwendung eines photolithographischen Ätzprozesses die Kontaktfläche 6' der Elektrodenschicht 4 auf der Substratoberfläche freigelegt werden.

Danach werden die Dotierungen der Zone 7 unter Verwendung der stehengebliebenen Teile der Oxidschicht in die freigelegte Oberfläche des Substrats 3 implantiert. Danach wird eine Schicht aus polykristallinem Silizium mit Dotierungen vom Leitungstyp der Zone 7 aufgebracht und abermals unter Anwendung eines zweiten photolithographischen Ätzprozesses die Elektrodenschicht 4 hergestellt. Dieser photolithographische Ätzprozeß hat lediglich zu gewährleisten, daß ein zumindest teilweise sich unter den Rand der Elektrodenschicht 4 erstreckender Schichtteil 5 aus dem Isoliermaterial der Oxidschicht 11 entsteht. Danach wird unter Verwendung der Elektrodenschicht 4 als Ätzmaskierungsschicht und einer den Kontaktbereich 2 freilassenden Photolackschicht das den Kontaktbereich 2 bedeckende Isoliermaterial weggeätzt. Der Photolack wird entfernt und dann über die gesamte obere Oberflächenseite des Substrats 3 Platin aufgedampft. Dann wird die Anordnung auf eine zur Bildung des Platinsilizides ausreichende Temperatur erhitzt, und die Anordnung in Königswasser eingetaucht, ein Ätzmittel, das zwar Platin angreift, Platinsilizid jedoch im wesentlichen nicht. Da die Dicke des Schichtteils 5 entsprechend der Lehre der Erfindung größer als die Dicke der Platinschicht ist, verbleibt auf der Flanke 52 des rahmenförmigen Schichtteils 5 lediglich ein rahmenförmiger Teil aus Platin, der wie der Teil aus Platin auf der Isolierschicht 11 bei dem Ätzprozeß selektiv entfernt wird. Es entsteht auf diese Weise eine Anordnung mit Platinsilizid-Kontaktflächen 1, 17, welche durch Öffnungen einer Fremdoxidschicht mittels Leiterbahnen in bekannter Weise verschaltet werden können.

Während bei dem anhand der Fig. 3 beschriebenen Ausführungsbeispiel der Schichtteil 5 als Teil einer begrenzenden Maskierung für einen Implantationsprozeß in die Oberfläche des Substrats vor der Herstellung der Elektrode 4 verwendet wird, kann diese Elektrode 4 natürlich auch in bekannter Weise selbst als Diffusionsquelle zur Eindiffusion der Zone 7 in das Substrat 3 Verwendung finden. In diesem Fall wird der Schichtteil 5 selbst als Teil einer Diffusionsmaske wirksam.

Anhand der Fig. 4 bis 10 wird im folgenden das bevorzugte Ausführungsbeispiel des Verfahrens nach der Erfindung zum Anbringen eines Kontaktes in unmittelbarer Nähe einer aus polykristallinem Silizium bestehenden Elektrodenschicht eines integrierten Bipolartransistors nach dem Verfahren der genannten EP-A1-71 665 erläutert. Dabei wird vom Stadium gemäß der Fig. 4 ausgegangen. Diese Fig. 4 zeigt als Ausschnitt einer monolithisch integrierten Festkörperschaltung die Kollektorzone 13 eines integrierten Bipolartransistors, die oberflächlich den Bereich 12 einnimmt. Der Bereich 12 wird begrenzt durch die Feldoxidschicht 11, welche durch Anwendung einer thermischen Oxidation und unter Verwendung einer Oxidationsmaskierungsschicht hergestellt worden ist, die den Bereich 12 bedeckte. Unter der Feldoxidschicht 11 befinden sich höher als das Substrat 3 dotierte Kanalunterbrecherzonen 14, deren Dotierungen vor der thermischen Oxidation der Feldoxidschicht 11 in die Oberfläche des Substrats 3 eingebracht wurden. Nach Entfernung der nichtgezeigten Oxidationsmaskierungsschicht werden die Dotierungen der Kollektorzone 13 unter Verwendung der Feldoxidschicht 11 als Maskierung eingebracht, so daß nach einem folgenden Erhitzungsprozeß die Kollektorzone 13 entsteht. Anschließend wird auf der freien Oberfläche der Anordung die

aus einer unteren $SiO_2$-Schicht und einer oberen $Si_3N_4$-Schicht bestehende Schichtenfolge einer weiteren Oxidationsmaskierungsschicht aufgebracht, aus welcher der den Emitterbereich 6 bedeckende Schichtteil 8 und am Rande der Kollektorzone ein das Feldoxid 11 überlappender Schichtteil 81 ausgeätzt wird. Auf diese Weise wird die Anordnung gemäß der Fig. 4 erhalten.

Anschließend wird gemäß der Fig. 5 eine Photolackmaske 15 aufgebracht, welche den Basisbereich freiläßt und dessen Begrenzung zusammen mit Teilen der Feldoxidschicht 11 – auf der rechten Seite der Fig. 5 – bildet. Es erfolgt nun die Implantation der Dotierungen der Basiszone, wobei in beliebiger Reihenfolge das eine Mal eine Implantation bei hoher Dosierung und niedriger Energie und das andere Mal eine Implantation bei hoher Energie und niedriger Dosierung erfolgt. Die Dicke der Oxidationsmaskierungsschicht 8 wird derart an die Implantationsbedingungen angepaßt, daß sie bei der hohen Energie durchdrungen werden kann, während Ionen mit niedriger Energie maskiert werden. Wie in der erwähnten EP-A1 71 665 beschrieben wird, wird auf diese Weise unter der Oxidationsmaskierungsschicht 8, also unterhalb der noch herzustellenden Emitterzone, die aktive Basiszone und unter den Teilen der freigelegten Substratoberfläche die negative Basiszone 91 erhalten, wie aus den folgenden Fig. 6 und 7 ersichtlich ist.

Anschließend wird die Photolackmaskierung 15, welche ebenfalls gegen die Implantationen der Ionen der Basiszone maskierte, entfernt und die freigelegte Substratoberfläche oxidiert, wobei die Oxidschicht 51 entsteht. Nunmehr werden die Schichtteile 8 und 81 der Oxidationsmaskierungsschicht entfernt, so daß eine Anordnung der Fig. 6 erhalten wird.

Nun erfolgt ein Implantationsprozeß von Dotierungen des Leitfähigkeitstyps der Emitterzone in ausreichend hoher Dosis, jedoch relativ geringer Beschleunigungsenergie. Anhand der Fig. 6 wird der Zweck der Oxidationsmaskierungsschicht 81 der Fig. 4 und 5 erkennbar, nämlich der Schutz gegen die Oxidation, bei der die Oxidschicht 51 erhalten wurde. Es werden nämlich bei der Implantation der Dotierungen der Emitterzone 7 auch die Dotierungen einer Kollektorkontaktierungszone 71 gemäß der Fig. 7 implantiert, wie durch die Pfeile angedeutet ist. Zur Herstellung der dotierten Elektrodenschicht 4 findet ein Aufdampfprozeß von polykristallinem Silizium, dessen Dotierung durch Ionenimplantation erfolgt, und ein photolithographischer Ätzprozeß zur Abgrenzung Anwendung. Wird die Herstellung der Schicht 7 durch Diffusion aus polykristallinem Silizium vorgenommen, so genügt es, den Emitterimplantationsprozeß nach dem Ätzprozeß des polykristallinen Siliziums vorzunehmen. Es entfällt dadurch die zusätzliche Implantation der polykristallinen Siliziumschicht.

Beim Herstellungsstadium gemäß der Fig. 7 beginnt das Verfahren der Erfindung. Zunächst wird ein photolithographischer Ätzprozeß, vorzugsweise unter Anwendung des anisotropen Trockenätzprozesses, wie er in der bereits erwähnten DE-A1 3 243 059 beschrieben ist, durchgeführt, um einen Teil der Halbleiteroberfläche der zu kontaktierenden inaktiven Basiszone 91 freizulegen, wie in Fig. 8 zu erkennen ist. Ein Teil der Oxidschicht 51, nämlich der an die Kollektorkontakierungszone 71 angrenzende Teil, wo der Basis-Kollektor-PN-Übergang an die Halbleiteroberfläche tritt, bleibt erhalten. Dies ist im rechten Teil der Fig. 8 nicht erforderlich, weil dort der Basis-Kollektor-PN-Übergang 13' an die Feldoxidschicht 11 und nicht an die freie Halbleiteroberfläche anstößt.

Der Ätzprozeß zur Entfernung der Oxidschicht 51 ist so zu führen, daß der rahmenförmige Schichtteil 5, den die Elektrodenschicht 4 überlappt, nicht unterbrochen wird und keine Hohlräume unter dem überlappenden Teil entstehen.

Bei der Herstellung der Emitterzone kann natürlich auch das bekannte Verfahren der Diffusion der Emitterzone aus der Elektrodenschicht 4 als Dotierungsquelle angewendet werden.

Nach Freilegung der Substratoberfläche im Bereich der inaktiven Basiszone gemäß der Fig. 8 wird die obere Oberflächenseite der Anordnung mit Platin bedampft und anschließend soweit erhitzt, daß Platinsilizid überall dort gebildet wird, wo das Silizium beim Bedampfen mit Platin freilag. Nach einem Ätzprozeß mit einem das Platin selektiv angreifenden Ätzmittel, wie Königswasser, wird eine Anordnung gemäß der Fig. 8 mit voneinander getrennten Schichten 1, 16, 17 aus Platinsilizid erhalten.

Bei der Anordnung gemäß der Fig. 8 ist der Kontakt 1 durch die aus Platinsilizid bestehende Oberflächenschicht der äußeren Basiszone 91 gegeben und liegt in unmittelbarer Nähe der Elektrodenschicht 4, nämlich im Abstand etwa der Dicke des rahmenförmigen Schichtteils 5, der von der Elektrodenschicht 4 überlappt wird. Der elektrische Anschluß der aktiven Basiszone 92 erfolgt also sehr niederohmig wie es bei Höchstfrequenztransistoren erwünscht ist. Natürlich ist der niederohmige Anschluß der aktiven Basiszone 92 umso besser, je weiter die aktive Basiszone 92 von dem rahmenförmigen Schichtteil 5 umgeben ist. Dabei ist jedoch zu berücksichtigen, daß die Basis-Kollektor-Kapazität mit wachsender PN-Übergangsfläche zunimmt und der Kollektorbahnwiderstand mit geringer werdender Fläche des Kollektorkontakts 16 abnimmt.

Die Fig. 10 zeigt eine Ausschnittsvergrößerung der Fig. 8 und läßt noch besser als diese die Hauptmerkmale und Vorteile des Verfahrens nach der Erfindung erkennen. Das Wesentliche der Erfindung besteht in der besonderen Ausnutzung des rahmenförmigen Schichtteils 5, auf dem der Rand der Elektrodenschicht 4 aufliegt, welche über diesen rahmenförmigen Schichtteil 5 mit dem Substrat verbunden ist. Die Dicke des Schichtteils 5 kann und sollte so bemessen werden, daß die Kapazität zwischen dem Kontakt 1 und der Elektrodenschicht 4 gegenüber der Emitterzone 7 und der Basiszone 91, 92 vernachlässigbar ist. Sie kann also ohne Nachteile wesentlich dicker als die beim Verfahren der Erfindung aufgebrachte Metallschicht bemessen werden, aus der das Silizid gebildet wird. Bei der Bemessung der Seitenerstreckung des Schichtteils 5 sind lediglich die Toleranzen des photolithographischen Ätzprozesses zu berücksichtigen, der zur Abgrenzung, der Elektrodenschicht 4 angewendet wird. Bei den Bedingungen, welche durch das Verfahren nach der Erfindung vorgegeben sind, ist auf jeden Fall ein Kurzschluß zwischen der Elektrodenschicht 4 und dem Kontakt 1 ausgeschlossen, da zumindest zwischen dem Kontakt 1 und der Elektrodenschicht 4 ein rahmenförmiger Schichtteil 5 in ausreichender Dicke vorhanden ist. Im übrigen hat die Bildung der Oxidschicht 51 und deren Entfernung im Bereich des Kontaktes 1 den Vorteil einer Versenkung des Kontaktes in die Oberfläche der äußeren Basiszone 91 zur Folge und damit eine nicht unbeachtliche weitere Verringerung des Basiszuleitungswiderstandes.

Zur Fertigstellung der integrierten Festkörperschaltungen sind noch zumindest an den Kontakten Leitbahnen anzubringen. Zu diesem Zweck werden gemäß der Fig. 9 eine Fremdoxidschicht 18 aufgebracht und unter Anwendung eines photolithographischen Ätzprozesses Kontaktierungslöcher zu den Kontakten 16, 1 und wahlweise zu der Elektrodenschicht 4 hergestellt, durch welche Kontaktierungslöcher die Leitbahnen 19 bzw. 19' die Kontakte und wahlweise auch die Elektrodenschicht 4 durch ein nichtgezeigtes Kontaktloch mit der Schaltung verbinden.

Abgesehen davon, daß durch das Verfahren der Erfindung beliebig kleine laterale Abstände zwischen dem Kontakt und der Elektrodenschicht eines Halbleiterbauelements, insbesondere bei Anwendung eines anisotropen Ätzverfahrens, möglich sind, ist ein besonderer Vorteil des Verfahren nach der Erfindung darin zu sehen, daß auch der Bahnwiderstand der aus polykristalinem Silizium bestehenden Leiterbahnen beträchtlich verringert ist, wenn die Elektrodenschicht 4 bzw. die Elektrodenschichten der integrierten Festkörperschaltung aus einer gemeinsamen polykristallinen Siliziumschicht geätzt werden. Beim Verfahren der Erfindung werden diese nämlich oberflächlich ebenfalls in ein Silizid umgewandelt. Das Verfahren der Erfindung kann also mit Vorteil bei integrierten Schaltungen angewendet werden, die sowohl Bipolartransistoren als auch Si-Gate-Feldeffekttransistoren enthalten. In diesem Zusammenhang ist zu erwähnen, daß durch das Verfahren der Erfindung auch eine sehr niederohmige Kontaktierung von MOS-Strukturen möglich ist, also beispielsweise bei Strukturen, zu deren Herstellung der rahmenförmige Schichtteil am Rande einer Isolatorschicht ausgebildet wird, deren Dicke weniger als die des rahmenförmigen Schichtteils 5 beträgt. Eine solche Elektrode wäre als Feldeffektelektrode eines Verarmungs-Feldeffekttransistors oder auch einer MOS-Kapazität verwendbar.

## Patentansprüche

1. Verfahren zum Anbringen eines Kontaktes (1) an einem Kontaktbereich (2) eines Substrats (3) aus Halbleitermaterial in unmittelbarer Nähe einer Elektrodenschicht (4) aus polykristallinem Silizium, das mit dem Substrat (3) an der Kontaktfläche (6') der Elektrodenschicht (4) verbunden ist, deren Rand zumindest teilweise über einen rahmenförmigen Schichtteil (5) aus einem Isoliermaterial mit dem Substrat (3) verbunden ist, dadurch gekennzeichnet,
   - daß unter Verwendung der Elektrodenschicht (4) zur seitlichen Begrenzung eines Ätzprozesses zumindest ein Teil der Flanke (52) des rahmenförmigen Schichtteils (5) und der daran angrenzende Kontaktbereich (2) des Substrates (3) freigelegt werden,
   - daß danach auf der freien Oberfläche der Anordnung eine Metallschicht aus einem ein Silizid bildenden Metall in einer Dicke geringer als die Dicke des Schichtteils (5) abgeschieden wird,
   - daß danach die Anordnung soweit erhitzt wird, daß das Metall mit dem darunterliegenden Silizium der Elektrodenschicht (4) und des Substrats (3) das Metallsilizid bildet, mit dem Isoliermaterial chemisch jedoch nicht reagiert, und
   - daß nach der Erhitzung und Abkühlung das Metall, das nicht mit Silizium reagierte, unter Verwendung eines selektiv das Metall lösenden Ätzmittels entfernt wird.

2. Verfahren nach Anspruch 1, dadurch gekennzeichnet, daß die Elektrodenschicht (4), welche den Rand des Schichtteils (5) zumindest teilweise über den Verlauf des Randes überlappt, Teil einer Leiterbahn des Leiterbahnmusters einer integrierten Festkörperschaltung ist, auf welchen Leiterbahnen die ein Silizid bildende Metallschicht abgeschieden wird.

3. Verfahren nach Anspruch 1 oder 2, dadurch gekennzeichnet, daß der mit dem Substrat (3) in Berührung stehende Rand der Elektrodenschicht (4) den Zonenbereich (6) einer Zone (7) begrenzt, welche unter Verwendung des Schichtteils (5) als Teil einer Maskierung in die Oberfläche des Substrats (3) vor der Herstellung der Elektrode (4) eingebracht wird.

4. Verfahren nach Anspruch 1 oder 2, dadurch gekennzeichnet, daß der Rand der Elektrodenschicht (4) den Zonenbereich (6) einer Zone (7) begrenzt, welche unter Verwendung des Schichtteils (5) als Teil einer Diffusionsmaske in die Oberfläche des Substrats (3) nach der Herstellung der Elektrodenschicht (4) aus dotiertem Silizium unter deren Verwendung als Diffusionsquelle zur Eindiffusion der Zone (7) in das Substrat (3) diffundiert wird.

5. Verfahren nach Anspruch 3 oder 4, dadurch gekennzeichnet, daß der Schichtteil (5) durch thermische Oxidation des Substrats (3) hergestellt wird, während der Zonenbereich (6) der Zone (7) mittels einer Oxidationsmaskierungsschicht (8) geschützt ist.

6. Verfahren nach Anspruch 5, dadurch gekennzeichnet, daß die Dicke der Oxidationsmaskierungsschicht (8) derart bemessen ist, daß diese Schicht (8) bei einem von zwei Implantationsprozessen einer an die Zone (7) angrenzenden Basiszone (9) eines integrierten Bipolartransistors durchdrungen wird, so daß eine Basiszone (9) mit einer inaktiven Basiszone (91) und einer dünnen aktiven Basiszone (92) unter der Zone (7) entsteht.

7. Verfahren nach Anspruch 1 oder 2, dadurch gekennzeichnet, daß der rahmenförmige Schichtteil (5) am Rande einer Isolatorschicht ausgebildet wird, deren Dicke kleiner als die des rahmenförmigen Schichtteils (5) ist.

## Claims

1. Method of attaching a contact (1) to a contact area (2) of a substrate strate (3) of semiconducting material in the direct proximity of an electrode layer (4) of polycrystalline silicon, which is bonded to the substrate (3) on the contact surface (6') of the electrode layer (4) whose rim portion is connected at least partially via a frame-shaped layer portion (5) of an insulating material, to said substrate (3), characterized in
  - that by using the electrode layer (4) for the lateral delimitation on an etching process, at least one part of the flank (52) of the frame-shaped layer portion (5) and the adjoining contact area (2) of the substrate (3) are exposed,
  - that thereafter, onto the free surface of the arrangement, there is deposited a metal layer of a metal forming a silicide, in a thickness which is less than the thickness of said layer portion (5),
  - that thereafter the arrangement is heated to such an extent that the metal, with the underliying silicon of the electrode layer (4) and of the substrate (3), forms the metal silicide, but does chemically not react with the insulating material, and
  - that, following both the heating and the cooling, the metal which has not reacted with the silicon, is removed with the aid of an etching agent selectively dissolving the metal.

2. A method as claimed in claim 1, characterized in that said electrode layer (4) which at least partly overlaps the rim portion of the layer portion (5) throughout the course of the rim portion, forms part of a conductor lead of a printed conductor pattern of an integrated solid-state circuit, with a metal layer forming a silicide being deposited on said conductor leads.

3. A method as claimed in claim 1 or 2, characterized in that the rim portion of the electrode layer (4) which is in contact with the substrate (3) restricts the regional area (6) of a region (7) which, by using the layer portion (5) as part of a masking, is brought into the surface of the substrate (3) prior to the fabrication of said electrode (4).

4. A method as claimed in claim 1 or 2, characterized in that the rim portion of the electrode layer (4) restricts the regional area (6) of a region (7) which, by using the layer portion (5) as part of a diffusion mask, is diffused into the surface of the substrate (3) following the fabrication of the electrode layer (4) from a doped silicon, by using the latter as a source of diffusion for diffusing the region (7) into the substrate (3).

5. A method as claimed in claim 3 or 4, characterized in that said layer portion (5) is produced by way of thermal oxidation of the substrate (3), during which the regional area (6) of the region (7) is protected by means of an oxidation masking layer (8).

6. A method as claimed in claim 5, characterized in that the thickness of said oxidation masking layer (8) is so dimensioned that this layer (8) is penetrated in the course of one of two implantation processes of a base region (9) bordering on the region (7) of an integrated bipolar transistor, so that underneath said region (7) a base region (9) with an inactive base region (91) an a thin active base region (92) will result.

7. A method as claimed in claim 1 or 2, characterized in that said frame-shaped layer portion (5) is embodied at the rim portion of an insulating layer whose thickness is smaller than that of said frame-shaped layer portion (5).

## Revendications

1. Procédé pour appliquer un contact (1) sur une plage de contact (2) d'un substrat (3) semi-conducteur à proximité directe d'une couche d'électrode (4) en silicium polycristallin qui est relié avec le substrat (3) sur la surface de contact (6') de la couche d'électrode (4) dont le flanc est relié tout au moins partiellement avec le substrat (3) par une partie de couche en forme de cadre (5) en matière isolante, caractérisé en ce que
  - par l'utilisation de la couche d'électrode (4) pour la délimitation latérale d'un processus d'attaque, tout au moins une partie du flanc (52) de la partie de couche en forme de cadre (5) et la plage de contact (2) du substrat (3) qui lui est adjacente sont dégagées,
  - ensuite, sur la surface dégagée de l'agencement, une couche métallique en un métal formant un siliciure est déposée en une épaisseur inférieure à l'épaisseur de la partie de couche (5),
  - puis l'agencement est chauffé jusqu'à ce que le métal forme, avec le silicium sous-jacent de la couche d'électrode (4) et du substrat (3), le siliciure métallique, sans réagir chimiquement avec la matière isolante, et
  - après le chauffage et le refroidissement le métal, qui n'a pas réagi avec le silicium, est éliminé par l'utilisation d'un agent d'attaque dissolvant sélectivement le métal.

2. Procédé selon la revendication 1, caractérisé en ce que la couche d'électrode (4) qui chevauche le flanc de la partie de couche (5) tout au mois partiellement le long de ce flanc, fait partie d'une piste conductive du réseau de pistes conductives d'un circuit intégré, pistes conductives sur lesquelles une couche métallique formant un siliciure est déposée.

3. Procédé selon l'une quelconque des revendications 1 ou 2, caractérisé en ce que le flanc en contact avec le substrat (3) de la couche d'électrode (4) délimite la région de zone (6) d'une zone (7) qui, par l'utilisation de la partie de couche (5), est introduite en tant que partie d'un masquage dans la surface du substrat (3) avant la réalisation de l'électrode (4).

4. Procédé selon l'une quelconque des revendications 1 ou 2, caractérisé en ce que le flanc de la couche d'électrode (4) délimite la région de zone (6) d'une zone (7) qui, par l'utilisation de la partie de couche (5), est diffusée en tant que partie d'un masquage de diffusion dans la surface du substrat (3) après la réalisation de la couche d'électrode (4) en silicium dopé, en utilisant celle-ci comme source de diffusion pour la diffusion de la zone (7) dans le substrat (3).

5. Procédé selon l'une quelconque des revendications 3 ou 4, caractérisé en ce que la partie de couche (5) est réalisée par oxydation thermique du substrat (3), tandis que la région de zone (6) de la zone (7) est protégée au moyen d'une couche de masquage d'oxydation (8).

6. Procédé selon la revendication 5, caractérisé en ce que l'épaisseur de la couche de masquage d'oxydation (8) est calculée de manière que cette couche (8) soit pénétrée au cours de l'un de deux processus d'implantation d'une zone de base (9)) d'un transistor bipolaire intégré adjacente à la zone (7), de sorte qu'une zone de base (9) possédant une zone de base inactive (91) et une zone de base active mince (92) soit créée sous la zone (7).

7. Procédé selon l'une quelconque des revendications 1 ou 2, caractérisé en ce que la partie de couche en forme de cadre (5) est formée sur le flanc d'une couche isolante dont l'épaisseur est inférieure à celle de la partie de couche en forme de cadre (5).

FIG. 1

FIG. 2

FIG. 3

FIG. 4

FIG. 5

FIG. 6

FIG. 7

FIG.8

FIG.9

FIG.10